# EUROPÄISCHE PATENTSCHRIFT

(11) **EP 0 864 168 B1**
(45) Veröffentlichungstag und Bekanntmachung des Hinweises auf die Patenterteilung: **05.02.2003**
(21) Anmeldenummer: 96946014.6
(22) Anmeldetag: 25.11.1996
(51) Int. Cl.: H01H 1/00

(54) **VERFAHREN UND VORRICHTUNG ZUM ÜBERWACHEN DES ABBRANDES DER KONTAKTSTÜCKE BEI EINEM SCHALTGERÄT**
METHOD AND DEVICE FOR MONITORING CONSUMPTION OF CONTACT ELEMENTS IN A SWITCHING DEVICE
PROCEDE ET DISPOSITIF POUR SURVEILLER L'USURE DES PIECES DE CONTACT D'UN APPAREIL DE COMMUTATION

(30) Priorität: 01.12.1995 DE 19544926
(43) Veröffentlichungstag der Anmeldung: 16.09.1998
(73) Patentinhaber: SIEMENS AKTIENGESELLSCHAFT, 80333 München (DE)
(72) Erfinder: GRIEPENTROG, Gerd, D-08066 Zwickau (DE); BRANSTON, David-Walter, D-91090 Effeltrich (DE); ELSNER, Norbert, D-91088 Bubenreuth (DE); MAIER, Reinhard, D-91074 Herzogenaurach (DE)
(86) Internationale Anmeldenummer: DE9602265
(87) Internationale Veröffentlichungsnummer: WO97021234

(56) Entgegenhaltungen:
- DE-A- 2 640 921
- DE-A- 2 727 378
- DE-A- 4 309 177

## Beschreibung

Die Erfindung bezieht sich auf ein Verfahren zum Überwachen des Abbrandes der Kontaktstücke bei einem Schaltgerät, insbesondere zur Beurteilung des Verschleißzustandes von Schützen, wobei beim Ausschaltvorgang die zwischen den sich öffnenden Kontaktstücken entstehende Lichtbogenspannung als Indikator für den Verschleißzustand der Kontakte erfaßt und bewertet wird. Daneben bezieht sich die Erfindung auch auf eine geeignete Vorrichtung zur Realisierung des Verfahrens.

Die Lebensdauer von Schaltkontaktstücken wird durch den Abbrand, d.h. den allmählichen Verlust des Kontaktmaterials unter dem Einfluß des beim Schaltvorgang entstehenden Lichtbogens, bestimmt. Der Abbrand wird dabei die Kontaktstücke in der Regel ungleichmäßig abtragen. Das Lebensdauerende der Schaltkontaktstücke ist dann erreicht, wenn im Kontaktbereich an mindestens einer Stelle das Kontaktmaterial entweder völlig erodiert oder auf eine definierte Mindestdicke abgetragen ist.

Entgegen vielfältiger theoretischer Ansätze wird in der Praxis der Zustand der Schaltkontaktstücke immer noch allein durch Öffnen des Schaltgerätes und durch visuelle Inspektion beurteilt. Dies gilt insbesondere für die noch zu erwartende Restlebensdauer, deren Kenntnis von zentraler Bedeutung für die Einsatzfähigkeit des Schaltgerätes und damit für die Betriebssicherheit des geschalteten Verbrauchers ist.

Aus der internationalen Anmeldung WO 94/22153 A1 ist bereits ein Schaltgerät bekannt, bei dem die Kontaktstücke rückseitig geschlitzt und auf einem geteilten Kontaktträger aufgebracht sind. Durch diese Anordnung kann in einfacher Weise die Restlebensdauer des Kontaktes bestimmt werden: Wenn der Abbrand das über dem Schlitz befindliche Material erodiert hat, entstehen zwei Kontakthälften. Beim Schalten in diesem Zustand tritt zwischen den beiden Kontakthälften eine Potentialdifferenz auf, die als Spannung gemessen und zur Anzeige für den Kontaktabbrand verwendet werden kann. Daneben ist aus der DE 37 14 802 A1 ein elektronischer Schalter bekannt, bei dem wenigstens einem der Kontaktstücke ein Lichtleiter zugeordnet ist, dessen Transmissionseigenschaften von außen mittels geeigneter optischer Hilfseinrichtungen gemessen werden können. Dabei soll ein unzulässig fortgeschrittener Kontaktabbrand zur Änderung der optischen Transmissionseigenschaften und schließlich zur Zerstörung des Lichtleiters führen.

Abgesehen von obigen Einrichtungen, mit denen die mechanische Erosion der Kontaktstücke erfaßt wird, gibt es auch Vorschläge, elektrische Signale in entsprechender Weise auszuwerten. Beispielsweise ist aus der DE 40 28 721 C2 ein Verfahren zur Ermittlung der Restlebensdauer von Schaltgeräten bekannt, bei dem die während eines Schaltvorganges geflossenen Ladungen elektronisch ermittelt und für die Schaltvorgänge aufsummiert werden. Dieses Verfahren ist vom Prinzip her nicht nur geeignet, eine definierte Restlebensdauer anzuzeigen, sondern darüber hinausgehend auch den Abbrandzustand der Kontaktstücke zu jedem beliebigen Zeitpunkt anzugeben.

Aufgabe der Erfindung ist es demgegenüber, ein vereinfachtes Verfahren anzugeben, das zur Beurteilung der Betriebsbereitschaft von Schützen geeignet ist, und eine zugehörige Vorrichtung zu schaffen.

Die Aufgabe ist erfindungsgemäß bei einem Verfahren der eingangs genannten Art dadurch gelöst, daß das Schwankungsmaß der Lichtbogenspannung als Kriterium für den Verschleißzustand der Kontaktstücke herangezogen wird. Vorzugsweise werden zur Erfassung des Schwankungsmaßes der Lichtbogenspannung die höherfrequenten Anteile der Lichtbogenspannung, insbesondere oberhalb von ca. 1 kHz, herangezogen. Dabei werden die höherfrequenten Anteile der Lichtbogenspannung nach einer Filterung quadriert. Die Quadrate können aufsummiert und mit einem Schwellenwert verglichen werden.

Demzufolge ist die erfindungsgemäße Vorrichtung durch eine Einrichtung gekennzeichnet, mit der das Schwankungsmaß der Lichtbogenspannung erfaßt und zur Beurteilung des Verschleißzustandes der Kontaktstücke herangezogen wird, wobei die Einrichtung eine Schaltungsanordnung aus einem Hochpaß, einem Quadrierglied, einem Integrator und einer Einheit zur Generierung eines Fehlersignals umfaßt.

Mit der Erfindung ist ein Verfahren und die zugehörige Vorrichtung geschaffen, mit denen für die Anwendung bei Schützen als Schaltgerät insbesondere der Zustand der Hauptkontakte, welche für die elektrische Lebensdauer des Schaltschützes verantwortlich sind, in einfacher Weise erkannt werden können. Vorteilhafterweise können dabei auch beim Schaltgerät bereits vorhandene Einheiten zur Signalerfassung verwendet werden.

Bei der Erfindung ist insbesondere vorteilhaft, daß keine dauerhafte Beobachtung des Schaltgerätes bzw. der Kontaktstücke notwendig ist, was beim eingangs genannten Stand der Technik erfolgen muß. Dies ist auch bei der DE 27 27 378 C2 notwendig, die eine Einrichtung zur Kontrolle der Betriebsfähigkeit von elektrischen Schaltgeräten beschreibt, bei der über eine laufende Messung der Strom am Kontakt gemessen und aufsummiert wird. Die Anordnungen gemäß der DE 44 16 781 A1 und DE 41 32 533 A1 beinhalten demgegenüber spezifische Verfahren zur Messung des Verlaufes des Löschfunkens bei Leistungsschaltern bzw. zur Bewertung des Lichtbogens an Gleitkontakten von elektrischen Maschinen.

Ein Hinweis auf das Wanderungsverhalten des Lichtbogens auf Kontaktstücken wird im VDE-Fachbericht 42 "Kontaktverhalten und Schalten" (11. Kontaktseminar vom 25. bis 27.09.1991 an der Universität Karlsruhe) gegeben. Dort wird im wesentlichen das Phänomen des sich bewegenden Lichtbogens untersucht, aber keine weitergehenden Folgerungen hinsichtlich einer Beurteilung des Verschleißzustandes der Kontaktstücke gezogen.

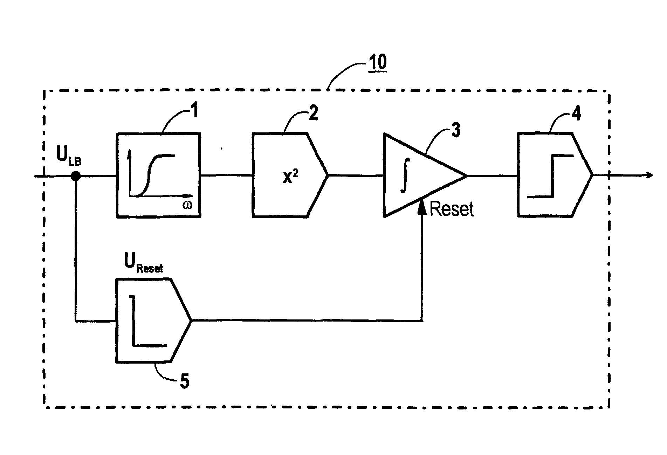

Weitere Einzelheiten und Vorteile der Erfindung ergeben sich aus der nachfolgenden Figurenbeschreibung eines Ausführungsbeispiels in Verbindung mit den weiteren Patentansprüchen. Die einzige Figur zeigt eine Auswerteeinheit für die Lichtbogenspannung, die beim Ausschaltvorgang eines Schaltgerätes zwischen den sich öffnenden Kontaktstücken entsteht.

Bei Schaltgeräten geht während des Ausschaltvorganges die sich zwischen den Kontaktstücken ausbildende Schmelzbrücke in einen zunächst sehr kurzen, sich aber mit zunehmender Kontaktöffnung aufweitenden Lichtbogen über. Dieser Lichtbogen bildet Fußpunkte auf den Kontaktauflagen der Schaltstücke, die insbesondere bei Schützen vorteilhafterweise aus Kontaktwerkstoffen auf Silber-Metalloxid-Basis, beispielsweise AgSnO₂, bestehen. Nach einer kurzen Verharrzeit beginnt der Lichtbogen, angetrieben durch eigenmagnetische Kräfte, eine gewünschte Wanderung in die üblicherweise vorhandenen Lichtbogenlöschkammer. Während dieser Bewegung ist der Lichtbogen gezwungen, seine Fußpunkte auf den Kontaktauflagen zu verlagern, was mit wechselnden energetischen Verhältnissen verbunden ist. Zur Deckung der schwankenden Verlustleistung wird dabei durch den Lichtbogen dem elektrischen Stromkreis eine korrespondierende Leistung entzogen. Da aufgrund der praktisch meist im Stromkreis vorhandenen Induktivitäten der Strom nicht in diesem starken Maße variieren kann, wird sich die Spannung des Lichtbogens an die wechselnden Verhältnisse anpassen, wodurch sich ein sogenanntes Schwankungsmaß ergibt.

Das Schwankungsmaß wird als Differenz aus dem Maximum und dem Minimum der auftretenden Lichtbogenspannung definiert. Es ist ursächlich einerseits mit der Bewegung des Lichtbogens, dessen Geschwindigkeit bei etwa 20 bis 40 m/s liegt, und andererseits mit den Inhomogenitäten auf der Kontaktstückoberfläche, bei denen Rauhigkeiten von etwa 100 bis 500 µm vorliegen, verknüpft. Beispielsweise bei einer Geschwindigkeit von 20 m/s und einer mittleren Rauhigkeit der Kontaktoberfläche von 200 µm ergibt sich eine auszuwertende Frequenz im Bereich von 100 kHz. Alle Größen hängen von Art und Zustand der Kontaktstücke ab, wobei sich in jedem Fall Frequenzen oberhalb von 1 kHz ergeben, so daß diese höherfrequenten Anteile der Lichtbogenspannung zu untersuchen sind.

Mit fortschreitendem Verschleiß der Kontaktauflage der Schaltstücke ist eine zunehmende Aufrauhung und Zerklüftung der Kontaktstückoberfläche festzustellen. Dies bedingt wiederum ein stärkeres Schwankungsmaß der Lichtbogenspannung während des Abwanderungsvorganges.

Letzterer Effekt tritt insbesondere dann verstärkt in Erscheinung, wenn die Kontaktauflage des Schaltstückes soweit verbraucht ist, daß zumindest partiell keine Kontaktwerkstoffauflage mehr vorhanden ist. In diesem Fall müßte der Lichtbogen Fußpunkte auf dem Trägermaterial, das üblicherweise aus Kupfer besteht, ausbilden, was einen Sprung in der zur Ladungsträgeremission notwendigen Kathodenfallspannung verursacht.

Das mit zunehmendem Kontaktverschleiß ansteigende Schwankungsmaß der Lichtbogenspannung kann erfaßt und zur Prognose des Verschleißzustandes der Schaltkontaktstücke herangezogen werden. Dazu ist in der Figur ein erster Anschluß an ein nicht dargestelltes Schaltgerät mit U_{LB} bezeichnet. Dem Anschluß U_{LB} ist ein Hochpaß 1 nachgeschaltet, der die höherfrequenten Anteile der Lichtbogenspannung während des Ausschaltvorganges ausfiltert, womit also die niederfrequenten Anteile der Lichtbogenspannung ausgeblendet werden. Das resultierende Signal wird einer betragsbildenden Operation unterzogen, beispielsweise dafür auf einen Quadrierer 2 gegeben, und nach Quadrierung durch einen Integrator 3 aufsummiert.

Bei Überschreitung eines vom jeweiligen Typ des Schaltgerätes abhängigen Wertes am Ausgang des Integrators 3 wird durch Vergleich mit dem Signal eines Schwellwertgenerators 4 ein entsprechendes Fehlersignal generiert und zur Anzeige gebracht. Dafür können entsprechende Anzeigegeräte in geeigneter Weise ausgebildet sein. Das so gelieferte Signal kann zur zentralen Kommunikation in ein Bussystem eingespeist werden.

Bei der Schaltungseinrichtung gemäß der Figur kann optional der Integrator 3 bei geschlossenen Hauptkontakten, d.h. U ≅ 0, rückgesetzt werden, um jeweils definierte Ausgangs zustände vor jeder Schaltung zu gewährleisten.

In Abwandlung der Schaltung gemäß der Figur kann das Hochpaßfilter 1 auch softwaremäßig durch Differenzbildung der Signale aus einem Tiefpaß emuliert werden. Dabei wird mit der Methode des exponentiellen Averagings vorgegangen und das so gebildete Signal vom Originalsignal subtrahiert.

## Patentansprüche

1. Verfahren zum Überwachen des Abbrandes der Kontaktstücke bei einem Schaltgerät, insbesondere zur Beurteilung des Verschleißzustandes von Schützen, wobei beim Ausschaltvorgang die zwischen den sich öffnenden Kontaktstücken entstehende Lichtbogenspannung als Indikator für den Verschleißzustand der Kontakte erfaßt und bewertet wird, **dadurch gekennzeichnet, daß** das Schwankungsmaß der Lichtbogenspannung als Kriterium für den Verschleißzustand der Kontaktstücke herangezogen wird.

2. Verfahren nach Anspruch 1, **dadurch gekennzeichnet, daß** zur Erfassung des Schwankungsmaßes der Lichtbogenspannung die höherfrequenten Anteile der Lichtbogenspannung, insbesondere oberhalb von ca. 1 kHz, untersucht werden.

3. Verfahren nach Anspruch 2, **dadurch gekennzeichnet, daß** die höherfrequenten Anteile der Lichtbogenspannung nach einer Filterung quadriert werden.

4. Verfahren nach Anspruch 3, **dadurch gekennzeichnet, daß** die höherfrequenten, quadrierten Anteile der Lichtbogenspannung während der Lichtbogentrenndauer integriert und das Integral mit einem Schwellenwert verglichen wird.

5. Verfahren nach Anspruch 4, **dadurch gekennzeichnet, daß** bei jeweils geschlossenen Kontaktstücken (U ≅ O) der Integralwert zurückgesetzt wird, um definierte Ausgangszustände vor jeder Schaltung zu gewährleisten.

6. Verfahren nach Anspruch 2, **dadurch gekennzeichnet, daß** zur Filterung der hochfrequenten Anteile ein Hochpaßfilter verwendet wird.

7. Verfahren nach Anspruch 2, **dadurch gekennzeichnet, daß** die höherfrequenten Anteile der Lichtbogenspannung durch Differenzbildung zwischen der Lichtbogenspannung und einem vorzugsweise durch gleitende Mittelwertbildung der Lichtbogenspannung erhaltenen Signal gewonnen werden.

8. Verfahren nach Anspruch 2, **dadurch gekennzeichnet, daß** das ausgewertete Signal mit einem Schwellenwert verglichen, hieraus die Restlebensdauer berechnet und diese Information zur Überwachung und Kontrollzwecken in ein Bussystem eingespeist wird.

9. Vorrichtung zur Realisierung des Verfahrens nach Anspruch 1 oder einem der Ansprüche 2 bis 8, mit einer Einrichtung zur Erfassung des Verschleißzustandes eines Schützes durch Auswertung der höherfrequenten Anteile der Lichtbogenspannung während des Ausschaltvorganges, **dadurch gekennzeichnet, daß** die Einrichtung eine Schaltungsanordnung (10) aus einem Hochpaß (1), einem Quadrierglied (2), einem Integrator (3) und einer Einheit (4) zur Generierung eines Indikatorsignals umfaßt, womit das Schwankungsmaß der Lichtbogenspannung erfaßt und zur Beurteilung des Verschleißzustandes der Kontaktstücke herangezogen wird.

10. Vorrichtung nach Anspruch 9, **dadurch gekennzeichnet, daß** die Einheit zur Generierung des Indikatorsignals ein Vergleichsglied (4) ist.

11. Vorrichtung nach Anspruch 10, **dadurch gekennzeichnet, daß** der Integrator (3) von einer Rücksetzeinheit (5) ansteuerbar ist.

12. Vorrichtung nach Anspruch 11, **dadurch gekennzeichnet, daß** das Hochpaßfilter durch Differenzbildung zwischen der tiefpaßgefilderten Lichtbogenspannung und der Lichtbogenspannung selbst implementiert wird.

## Claims

1. Method for monitoring the erosion of contact elements in a switching device, in particular in order to assess the state of wear of contactors by measuring and evaluating the arc voltage generated between the contact elements as they open during the shut-off operation as an indicator of the state of wear of the contacts, **characterised in that** the fluctuation in arc voltage is used as a criterion for determining the state of wear of the contact elements.

2. Method according to Claim 1, **characterised in that** the higher-frequency components of the arc voltage, in particular those components above approximately 1 kHz, are used for measuring the fluctuation in arc voltage.

3. Method according to Claim 2, **characterised in that** the higher-frequency components of the arc voltage are filtered and then squared.

4. Method according to Claim 3, **characterised in that** the higher-frequency, squared components of the arc voltage are integrated during the arc separation period and the integral is compared to a threshold value.

5. Method according to Claim 4, **characterised in that** the integral value is reset each time the contact elements close (U ≅ 0) in order to guarantee defined initial states before each switching operation.

6. Method according to Claim 2, **characterised in that** a high-pass filter is used for filtering the high-frequency components.

7. Method according to Claim 2, **characterised in that** the higher-frequency. components of the arc voltage are obtained by forming a difference between the arc voltage and a signal that is preferably generated by computing the moving average of the arc voltage.

8. Method according to Claim 2, **characterised in that** the evaluated signal is compared to a threshold value, the remaining service life calculated on this basis, and this information supplied to a bus system for monitoring and control purposes.

9. Device for implementing the method according to Claim 1 or one of Claims 2 to 8, with a unit for measuring the state of wear of a contactor by evaluating the higher-frequency components of the arc voltage during the shut-off operation, **characterised in that** the unit has a circuit arrangement (10) comprising a high-pass filter (1), a squaring circuit (2), an integrator (3) and an indicator signal generating unit (4), with which the fluctuation in arc voltage is measured and the state of wear of the contact elements is assessed.

10. Device according to Claim 9, **characterised in that** the indicator signal generating unit is a comparator (4).

11. Device according to Claim 10, **characterised in that** the integrator (3) can be controlled by a resetting unit (5).

12. Device according to Claim 11, **characterised in that** the high-pass filter is implemented by forming the difference between the low-pass-filtered arc voltage and the arc voltage itself.

## Revendications

1. Procédé de surveillance de l'usure des pièces de contact d'un appareil de commutation, notamment pour juger de l'état d'usure de contacteurs, dans lequel on relève et on évalue, lors d'une opération d'ouverture, la tension d'arc électrique qui se crée entre les pièces de contact qui s'ouvrent comme indicateur de l'état d'usure des contacts, **caractérisé en ce que** l'on utilise la valeur de fluctuation- de la tension de l'arc électrique comme critère pour l'état d'usure des pièces de contact.

2. Procédé suivant la revendication 1, **caractérisé en ce que**, pour relever la valeur de fluctuation de la tension de l'arc électrique, on utilise les composantes haute fréquence de la tension de l'arc électrique, notamment au-dessus d'environ 1 kHz.

3. Procédé suivant la revendication 2, **caractérisé en ce que** l'on élève au carré avec un filtrage les composantes haute fréquence de la tension de l'arc électrique.

4. Procédé suivant la revendication 3, **caractérisé en ce que** l'on intègre les composantes haute fréquence élevées au carré de la tension de l'arc électrique pendant la durée de séparation de l'arc électrique et on compare l'intégrale à une valeur de seuil.

5. Procédé suivant la revendication 4, **caractérisé en ce que**, pour chaque pièce de contact fermée (U ≅ O), on remet à sa valeur initiale la valeur de l'intégrale pour assurer des états définis d'origine en avant de chaque montage.

6. Procédé suivant la revendication 2, **caractérisé en ce que** l'on utilise pour la filtration des composantes haute fréquence un filtre passe-haut.

7. Procédé suivant la revendication 2, **caractérisé en ce que** l'on obtient les composantes haute fréquence de la tension d'arc électrique en formant la différence entre la tension de l'arc électrique et un signal, obtenu de préférence par formation d'une moyenne mobile de la tension de l'arc électrique.

8. Procédé suivant la revendication 2, **caractérisé en ce que** l'on compare le signal évalué à une valeur de seuil, on en calcule la durée de vie restante et on envoie cette information à un système de bus à des fins de surveillance et de contrôle.

9. Dispositif pour réaliser le procédé suivant la revendication 1 ou l'une des revendications 2 à 8, comprenant un dispositif destiné à relever l'état d'usure d'un contacteur en exploitant les composantes haute fréquence de la tension de l'arc électrique pendant l'opération d'ouverture, **caractérisé en ce que** le dispositif comprend un montage (10) constitué d'un passe-haut (1), d'un élément (2) d'élévation au carré, d'un intégrateur (3) et d'une unité (4) destinée à engendrer un signal d'indicateur par lequel on relève la valeur de la fluctuation de la tension de l'arc électrique et on en tire parti pour juger de l'état d'usure des pièces de contact.

10. Dispositif suivant la revendication 9, **caractérisé en ce que** l'unité destinée à engendrer le signal d'indicateur est un élément (4) de comparaison.

11. Dispositif suivant la revendication 10, **caractérisé en ce que** l'intégrateur (3) peut être commandé par une unité (5) de remise à l'état initial.

12. Dispositif suivant la revendication 10, **caractérisé en ce que** le filtre passe-haut est réalisé par formation de la différence entre la tension de l'arc électrique filtrée par le passe-bas et la tension elle-même de l'arc électrique.
